# EUROPEAN PATENT SPECIFICATION

(11) **EP 3 347 777 B1**
(45) Date of publication and mention of the grant of the patent: **31.03.2021**
(21) Application number: 16770349.5
(22) Date of filing: 17.08.2016
(51) Int. Cl.: G05B 19/402, B65H 23/032, C23C 16/54, C23C 14/56, C23C 16/00, C23C 14/00, G05B 19/404, C23C 14/54

(54) **DEPOSITION SYSTEM**
ABSCHEIDUNGSSYSTEM
SYSTÈME DE DÉPÔT

(30) Priority: 09.09.2015 US 201562216214 P
(43) Date of publication of application: 18.07.2018
(73) Proprietor: Flisom AG, 8155 Niederhasli (CH)
(72) Inventor: WEPFER, Marc, CH-8472 Seuzach (CH); BUQAEI, Hamzeh, Riyadh, 11491 (SA)
(86) International application number: PCT/IB2016/001139
(87) International publication number: WO 2017/042614

(56) References cited:
- EP-A1- 2 128 059
- JP-A- 2010 265 062
- US-A1- 2014 319 194

## Description

### BACKGROUND

### Field

Embodiments of the present disclosure generally relate to a deposition system for conveying a flexible substrate in a processing environment and more particularly for a deposition system for conveying a flexible substrate past one or more evaporation sources for depositing one or more materials on the substrate.

### Description of the Related Art

A roll-to-roll deposition process is commonly used to form thin film solar cell, battery and other commercial electronic devices, such as CIGS (copper-indium-gallium-(di)selenide) solar cell devices. During processing, equipment in a deposition system is generally used to unwind a flexible substrate (also referred to as the "web") from a payout roll, guide the flexible substrate through a processing region, and then rewind the flexible substrate on a pickup roll. In one example, a series of evaporation sources are used to deposit the different elements of the CIGS absorber layer of a solar cell in the processing region. Typically, these types of deposition processes are performed within a vacuum chamber, which imposes limitations on the access to the deposition devices, roll-to-roll substrate and substrate transfer systems to correct defects in these systems during processing. Space is also typically constrained in the case of a roll-to-roll deposition system where the roll-to-roll mechanism must be contained within a desirably small processing region of the vacuum chamber.

Although care is taken before and during the startup of the deposition system to assure that the proper placement of the flexible substrate in the processing region is achieved and the proper amount of tension is applied to the substrate throughout the deposition system, waves or wrinkles may still form on the flexible substrate for various reasons causing stress in the substrate and deposited layers at various locations on the flexible substrate during processing. This stress can damage the flexible substrate and reduce the yield of devices, such as solar cells, formed on the flexible substrate.

Therefore, there is a need for improvements to enable a flexible substrate to be conveyed through a deposition system in an automated fashion without any significant formation of waves and stress on or within the transported flexible substrate and deposited film layers

US 2014/319194 A1, EP 2 128 059 A1 and JP 2010 265062 A disclose web-steering mechanisms using optical edge sensors for controlling the lateral position of an unwinder.

### SUMMARY OF THE DISCLOSURE

Embodiments of the present disclosure generally relate to a deposition system for conveying a flexible substrate in a processing environment and more particularly for a deposition system for conveying a flexible substrate past one or more evaporation sources for depositing one or more materials on the substrate.

In one embodiment, a deposition system for guiding a flexible substrate along a path is provided, as defined in claim 1.

In another embodiment, a method is provided for depositing a layer on a flexible substrate, as defined in claim 13.

### BRIEF DESCRIPTION OF THE DRAWINGS

So that the manner in which the above recited features of the present invention can be understood in detail, a more particular description of the invention, briefly summarized above, may be had by reference to embodiments, some of which are illustrated in the appended drawings. It is to be noted, however, that the appended drawings illustrate only typical embodiments of this invention and are therefore not to be considered limiting of its scope, for the invention may admit to other equally effective embodiments.
Figure 1A is a side cross-sectional view of a deposition system, according to one embodiment.
Figure 1B is a partial top view of a payout section of the deposition system illustrated in Figure 1A, according to one embodiment.
Figure 1C is a partial top view of a pickup section of the deposition system illustrated in Figure 1A, according to one embodiment.
Figure 1D is a perspective view of an exemplary sensor assembly to be used in the deposition system of Figure 1A, according to one embodiment.
Figure 2 is a process flow diagram of a method to control the alignment of the substrate, according to one embodiment.
Figure 3 is a process flow diagram of a method for controlling the tension on the flexible substrate, according to one embodiment.
Figure 4 is a partial sectional view of a deposition assembly included in the deposition system of Figure 1A.

To facilitate understanding, identical reference numerals have been used, where possible, to designate identical elements that are common to the figures. It is contemplated that elements disclosed in one embodiment may be beneficially utilized on other embodiments without specific recitation.

### DETAILED DESCRIPTION

In the following, reference is made to embodiments. However, it should be understood that the disclosure is not limited to specific described embodiments. Furthermore, although embodiments described herein may achieve advantages over other possible solutions and/or over the prior art, whether or not a particular advantage is achieved by a given embodiment is not limiting of the claimed subject matter. Thus, the following aspects, features, embodiments and advantages are merely illustrative and are not considered elements or limitations of the appended claims except where explicitly recited in a claim(s).

Embodiments of the present disclosure generally relate to a deposition system for conveying a flexible substrate and more particularly for a deposition system for conveying a flexible substrate past one or more evaporation sources for depositing one or more materials on the substrate. Embodiments of the disclosure may generally provide an automated flexible substrate transport system that is able control the transport of a flexible substrate through a processing chamber so that the properties of one or more layers formed thereon are improved and the amount of distortion and stress within the flexible substrate are reduced and/or consistently maintained.

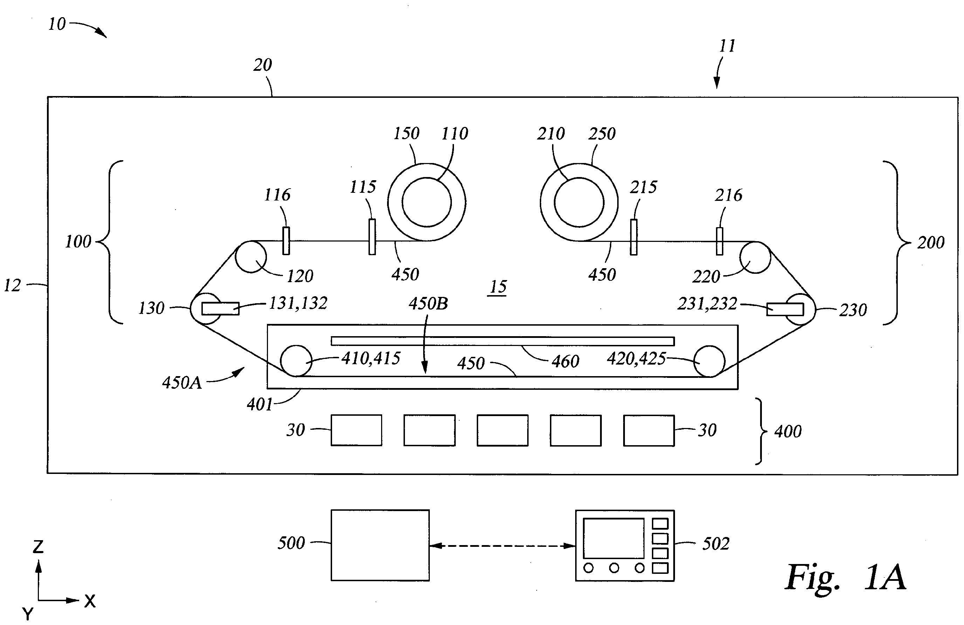

Figure 1A is a side cross-sectional view of a deposition system 10, according to one embodiment. The deposition system 10 is a roll-to-roll system for depositing material layers onto a flexible substrate 450. In some embodiments, the deposition system 10 can be a vacuum deposition system used to perform depositions on the flexible substrate 450 in a vacuum environment. In other embodiments, the deposition system 10 may also be used to process a substrate 450 at other pressures besides vacuum pressures. Although the remainder of the disclosure is largely described as a deposition system, aspects of the disclosure may also be applied to equipment used to transport, convey, or translate the substrate 450 in the absence of a deposition, such as a substrate transport system that transports the substrate 450 from a payout hub to a pickup hub. The flexible substrate 450 can be, for example, a web or foil of flexible polyimide or stainless steel material. The deposition system 10 includes a deposition assembly 11, a controller 500, and an operator station 502.

The controller 500 is generally used to facilitate the control and automation of the components within the equipment included in the deposition assembly 11 as well as related equipment connected to or associated with the deposition assembly 11. In one embodiment, the deposition assembly is a vacuum deposition assembly configured to process the substrate 450 in a vacuum environment. The operator station 502 can provide status of the deposition assembly 11 to a user as well as allow the user to control the processes executed with the equipment in the deposition system 10, such as allowing the user to start and stop the transport of the flexible substrate 450 through the deposition assembly 11. The controller 500 can be, for example, a computer, a programmable logic controller, or an embedded controller. The controller 500 typically includes a central processing unit (CPU) (not shown), memory (not shown), and support circuits for inputs and outputs (I/O) (not shown). The CPU may be one of any form of computer processors that are used in industrial settings for controlling various system functions, substrate movement, chamber processes, and control support hardware (e.g., sensors, motors, evaporation sources, heaters, etc.), and monitor the processes performed in the system (e.g., substrate tension, I/O signals, etc.). The memory is connected to the CPU, and may be one or more of a readily available nonvolatile memory, such as random access memory (RAM), flash memory, read only memory (ROM), floppy disk, hard disk, or any other form of digital storage, local or remote. Software instructions and data can be coded and stored within the memory for instructing the CPU. The support circuits are also connected to the CPU for supporting the processor in a conventional manner. The support circuits may include cache, power supplies, clock circuits, input/output circuitry, subsystems, and the like. A program (or computer instructions) readable by the controller 500 determines which tasks are performable on the substrate 450 in the deposition assembly 11. Preferably, the program is software readable by the controller 500 that includes code to perform tasks relating to monitoring, execution and control of the movement, support, and/or positioning of the substrate 450 along with the various process tasks and various sequences being performed in the controller 500 (e.g., starting up or shutting down the deposition assembly 11). The operator station 502 may include a wired or wireless computing device that contains various user input devices, such as a touch screen display, keyboard and buttons, and an output device, such as a GUI display, LED lights or other similar device.

The deposition assembly 11 includes a deposition chamber 20 (e.g., a vacuum chamber) including one or more walls 12 for enclosing an interior 15 of the deposition chamber 20. Inside the deposition chamber 20, the deposition assembly 11 includes a payout section 100 for unwinding the flexible substrate 450 from the payout roll 150, a processing section 400 for performing a deposition on the flexible substrate 450, and a pickup section 200 for rewinding the flexible substrate 450 onto the pickup roll 250 after processing. The processing section 400 includes one or more evaporation sources 30 for depositing one or more materials on the flexible substrate 450 and a master transport assembly 401.

The deposition system 10 guides the flexible substrate 450 along a path from the payout roll 150 in the payout section 100, through the processing section 400, and to the pickup roll 250 in the pickup section 200. The payout roll 150 is a roll of the unprocessed flexible substrate 450, such as a roll of polyimide foil or a roll of polyimide foil coated by one or more layers that include one or more metals, such as molybdenum. The payout roll 150 is placed on a payout hub 110 before processing of the flexible substrate 450 begins. The payout hub 110 can rotate to unwind the flexible substrate 450 from the payout roll 150. The payout roll 150 decreases in diameter as the flexible substrate 450 is unwound from the payout roll 150. The pickup roll 250 is a roll that includes the processed flexible substrate 450, for example, after the one or more evaporation sources 30 have deposited one or more materials on the flexible substrate 450. The pickup roll 250 is formed around a pickup hub 210. The pickup hub 210 can rotate to wind the flexible substrate 450 onto the pickup roll 250. The pickup roll 250 increases in diameter as the flexible substrate 450 is wound onto the pickup roll 250.

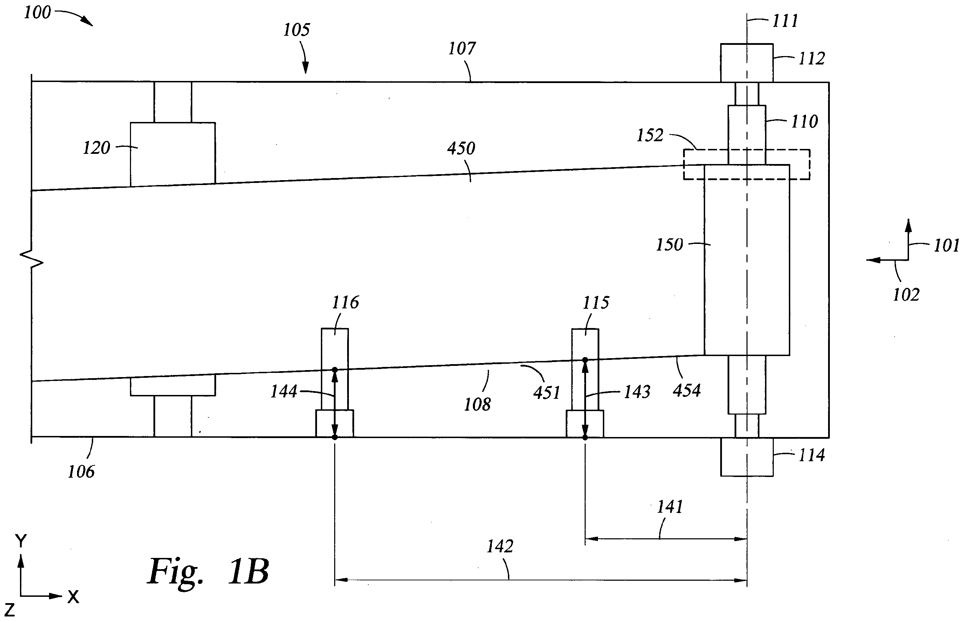

The payout section 100 can include a first payout roller 120 (first roller) and a second payout roller 130 to assist in guiding the flexible substrate 450 to the processing section 400. The first payout roller 120 is closer to the payout hub 110 than the second payout roller 130 is to the payout hub 110. The first payout roller 120 and the second payout roller 130 also assist in providing the proper tension to the flexible substrate 450 as the flexible substrate 450 is guided into the processing section 400. A first payout tension sensor 131 and, optionally, a second payout tension sensor 132 can be connected to the controller 500 to monitor the tension of the flexible substrate 450 as the flexible substrate 450 is guided into the processing section 400. The payout tension sensors 131, 132 can be positioned to monitor the tension on opposing sides, or lateral edges, of the flexible substrate 450 (i.e., the opposing sides/edges in the Y-direction of Figure 1A). The payout tension sensors 131, 132 can be force sensors, such as strain gauges. In some embodiments, the payout tension sensors 131, 132 can be mounted to a structural support (not shown) that is used to support the second payout roller 130, such as a support on the rotational axis of the second payout roller 130. The measurements from the payout tension sensors 131, 132 can be used to adjust the speed of a payout hub motor 114 (see Figure 1B) that rotates the payout hub 110 in order to maintain proper tension on the substrate 450 at the location of the payout tension sensors 131, 132.

The payout section 100 may also include a first position sensor 115 (first sensor) and a second position sensor 116 (second sensor) to detect the position of the edge of the flexible substrate 450 in the lateral direction (i.e., X-Y plane), such as the edge 454 described below in reference to Figure 1B. The position sensors 115, 116 can be disposed between the payout hub 110 and the first payout roller 120. The position sensors 115, 116 can be, for example, optical sensors and are described in further detail below.

The master transport assembly 401 in the processing section 400 can include one or more payout tractors 410, 415 and, optionally, one or more pickup tractors 420, 425 to assist in conveying the flexible substrate 450 through the processing section 400. The payout tractors 410, 415 are positioned closer to the payout section 100 than the pickup tractors 420, 425 are to the payout section 100. The payout tractors 410, 415 include a first payout tractor 410 and, optionally, a second payout tractor 415. The payout tractors 410, 415 can be positioned to engage opposing sides (i.e., the opposing sides in the Y-direction of Figure 1A) of the flexible substrate 450. For example, the first payout tractor 410 may be positioned to engage the left side of the flexible substrate 450, and the second payout tractor 415 may be positioned to engage the right side of the flexible substrate 450 when looking down (i.e., -Z-direction) on a given length of the flexible substrate 450. In one embodiment, the first payout tractor 410 can be coupled to the second payout tractor 415 by a common axle, and the first payout tractor 410 may be driven by a motor. However, in other embodiments a differential gear, or separate motors, may be used to enable a variance of the speed of the payout tractors 410, 415 relative to each other.

The pickup tractors 420, 425 are positioned closer to the pickup section 200 than the payout tractors 410, 415 are to the pickup section 200. The pair of pickup tractors 420, 425 include a first pickup tractor 420 and a second pickup tractor 425. The pickup tractors 420, 425 can be positioned to engage opposing sides (i.e., the opposing sides in the Y-direction of Figure 1A) of the flexible substrate 450. For example, the first pickup tractor 420 may be positioned to engage the left side of the flexible substrate 450, and the second pickup tractor 425 may be positioned to engage the right side of the flexible substrate 450 when looking down (i.e., -Z-direction) on a given length of the flexible substrate 450. In one embodiment, the first pickup tractor 420 is coupled to the second payout tractor 425 by a common axle, and the first pickup tractor 420 may be driven by a motor. However, in other embodiments a differential gear, or separate motors, may be used to enable a variance of the speed of the pickup tractors 420, 425 relative to each other. Furthermore, in some embodiments the payout tractors 410, 415 may be mechanically linked to the pickup tractors 420, 425, such as by using a chain between the payout tractors 410, 415 and the pickup tractors 420, 425. However, in some embodiments, the payout tractors 410, 415 may be driven independently of the pickup tractors 420, 425 by using separate actuators (e.g., motors) to allow operation at the same speed or different speeds and allowing for asymmetrical slack and tension of the flexible substrate 450 to be corrected.

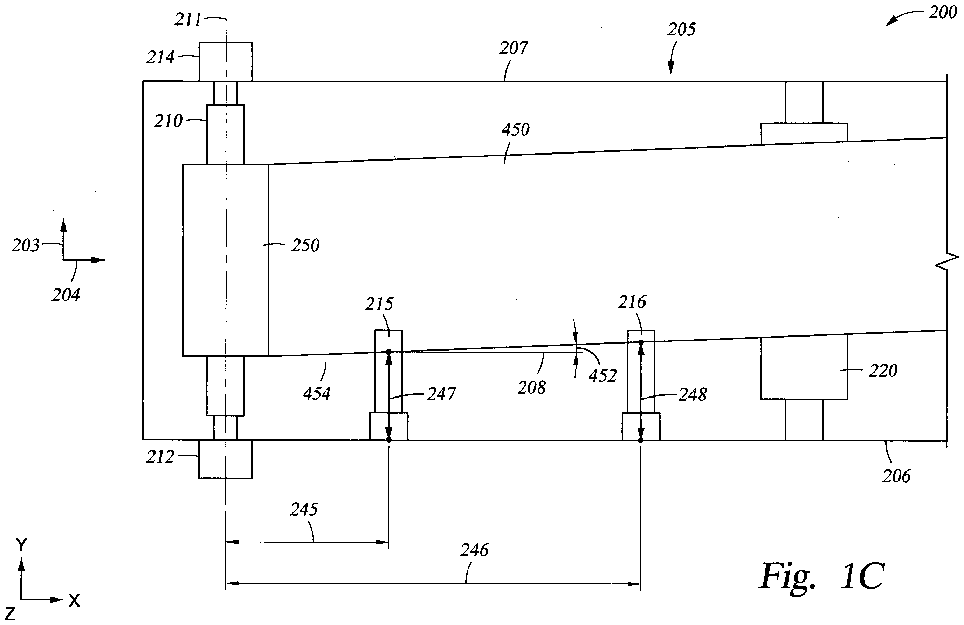

The processing section 400 further includes the one or more evaporation sources 30 and a heating assembly 460. The one or more evaporation sources 30 can heat material inside the one or more of the evaporation sources 30 causing the material to evaporate. The evaporated material can then be directed towards the flexible substrate 450 as the flexible substrate 450 is conveyed past the one or more evaporation sources 30. Evaporation sources that are used to deposit metals (e.g., copper (Cu), indium (In), gallium (Ga)) and/or dielectric materials are typically operated at temperatures that exceed 1000°C. The heat from the evaporation sources can cause other equipment (e.g., structural supports, sensors, etc.) in the deposition assembly 11 and the flexible substrate 450 to heat up and expand. In some cases this expansion can cause the flexible substrate 450 to become misaligned, which can cause high stress within areas of the flexible substrate 450 when the flexible substrate 450 is being conveyed through the deposition assembly 11. The expansion can also cause the flexible substrate 450 to become wrinkled due to a created difference in tension across the transfer direction length (X-direction) and/or lateral direction length (i.e., Y-direction). This misalignment and tendency of the flexible substrate 450 to wrinkle can be corrected in the pickup section 200 as described below in reference to Figure 1C.

A front side 450A of the flexible substrate 450 may face the one or more evaporation sources 30. In one embodiment, the evaporation sources 30 include an evaporation source for each one of the elements included in a CIGS layer of a solar cell device. A backside 450B of the flexible substrate 450 may face the heating assembly 460. The heating assembly 460 may include a plurality of independently controllable heating elements to allow for temperature control of the processing section 400.

The pickup section 200 can include a first pickup roller 220 (second roller) and a second pickup roller 230 to assist in guiding the flexible substrate 450 from the processing section 400 to the pickup hub 210. The first pickup roller 220 is closer to the pickup hub 210 than the second pickup roller 230 is to the pickup hub 210. The first pickup roller 220 and the second pickup roller 230 also assist in providing proper tension to the flexible substrate 450 as the flexible substrate 450 is conveyed to the pickup hub 210. A first pickup tension sensor 231 and, optionally, a second pickup tension sensor 232 can be connected to the controller 500 to monitor the tension of the flexible substrate 450 as the flexible substrate 450 is conveyed into the pickup section 200. The pickup tension sensors 231, 232 can be positioned to monitor the tension on opposing sides (i.e., the opposing sides in the Y-direction of Figure 1A) of the flexible substrate 450. The pickup tension sensors 231, 232 can be force sensors, such as strain gauges. In some embodiments, the pickup tension sensors 231, 232 can be mounted to a structural support (not shown) that is used to support the second pickup roller 230, such as a support on the rotational axis of the second pickup roller 230. The measurements from the pickup tension sensors 231, 232 can be used to adjust the speed of a pickup motor 214 (see Figure 1C) that rotates the pickup hub 210 in order to maintain proper tension on the substrate 450 at the location of the pickup tension sensors 231, 232.

The pickup section 200 may also include a third position sensor 215 (third sensor) and a fourth position sensor 216 (fourth sensor) to detect the position of the edge of the flexible substrate 450 in the lateral direction (i.e., X-Y plane) in the pickup section 200. The position sensors 215, 216 are disposed between the pickup hub 210 and the first pickup roller 220. The position sensors 215, 216 can be, for example, optical sensors and are described in further detail below.

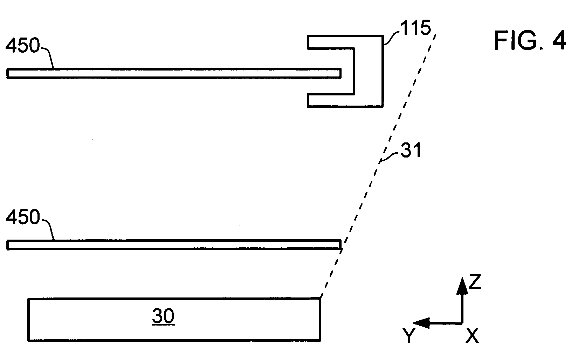

In some embodiments, the different pieces of equipment in the deposition chamber 20 are arranged so that there is no line of sight from the evaporation sources 30 to the payout hub 110, the pickup hub 210, the first actuator 112, the second actuator 212, or to any of the position sensors 115, 116, 215, 216 when the flexible substrate 450 is connected from the payout hub 110 to the pickup hub 210. For example, Figure 4 is a partial sectional view of the deposition assembly 11 included in the deposition system 10 of Figure 1A and Figure 4 illustrates how there is no line of sight between the evaporation sources 30 and the position sensor 115. The line of sight from the evaporation sources 30 is indicated by the dashed line 31. Preventing a line of sight between the evaporation sources 30 and these other pieces of equipment can help to prevent materials from the evaporation sources 30 from depositing on these other pieces of equipment. Deposition of substantial amounts of material on these other pieces of equipment can affect the performance of these other pieces of equipment. For example, in some embodiments the position sensors (e.g., the first position sensor 115) are optical sensors and the material deposited on the sensor can affect the amount of light received by the sensor and cause inaccurate measurements. Furthermore, the deposition material can deposit inside moving parts, such as the payout hub 110 and the first actuator 112 and cause excessive wear and tear.

Figure 1B is a partial top view of the payout section 100 of the deposition system 10, according to the embodiment of Figure 1A. The payout section 100 includes a first frame 105 having a first sidewall 106 and a second sidewall 107 separated from each other in a first direction 101 (i.e., the Y-direction of Figure 1B). The first frame 105 can be used to provide structural support for at least some of the equipment in the payout section 100, such as the payout hub 110 and the first payout roller 120. The payout hub 110 may be disposed between and coupled to the first sidewall 106 and the second sidewall 107 of the first frame 105. The payout hub 110 has a rotational axis 111 extending in the first direction 101. A payout hub motor 114 can be coupled to the payout hub 110 and can be used to rotate the payout hub 110. The first payout roller 120 is separated from the payout hub 110 in a second direction 102 (i.e., the -X-direction of Figure 1B). A length of the substrate 450 extends in the second direction 102 from the payout hub 110 to the first payout roller 120 during processing. The first direction 101 and the second direction 102 can each be horizontal and the second direction 102 can be substantially perpendicular to the first direction 101.

The first position sensor 115 is located a first distance 141 in the second direction 102 from the rotational axis 111 of the payout hub 110. In one embodiment the first position sensor 115 may be located at a close distance from the payout roll 150, such as within 3 cm of the surface of the payout roll 150 when the payout roll 150 has a maximum diameter. For example, in one embodiment the first position sensor 115 may be located at a minimum distance from that payout roll 150 that still provides enough space to load or unload the payout roll 150. The second position sensor 116 is located a second distance 142 in the second direction 102 from the rotational axis 111 of the payout hub 110. The second distance 142 is further (e.g., from about 0.5 to about 4 times the width of the substrate 450, such as from about 1.5 to about 2 times the width of the substrate 450) from the payout hub 110 than the first distance 141 is from the payout hub 110. In some embodiments, the first position sensor 115 and the second position sensor 116 can each be mounted to one of the sidewalls of the first frame 105, such as the first sidewall 106. The first position sensor 115 can be configured to measure a third distance 143 of an edge 454 of the substrate 450 from the first sidewall 106 at the first distance 141 from the payout hub 110. The second position sensor 116 can be configured to measure a fourth distance 144 of the edge 454 of the substrate 450 from the first sidewall 106 at the second distance 142 from the payout hub 110.

The measurements of the third distance 143 and the fourth distance 144 can be used to determine when the substrate 450 is aligned in the first direction 101 along the length of the substrate 450 in the second direction 102. For example, when the substrate 450 is aligned in the first direction 101 along the length of the substrate 450 in the second direction 102, the third distance 143 and the fourth distance 144 are equal when the first sidewall 106 and the second direction 102 are parallel. When the substrate 450 is not aligned in the first direction 101 along the length of the substrate 450 in the second direction 102, a first angle 451 is formed between the edge 454 of the substrate 450 and a first line 108 that is parallel to the second direction 102. The first line 108 can also be parallel to the first sidewall 106. In Figure 1B, the first line 108 extending from the edge 454 of the substrate 450 at the location of the second position sensor 116 is used as an example, but the first line may extend from other locations as well. The edge 454 of the substrate 450 can be the edge of the substrate 450 that is closest to the first sidewall 106. The first line 108 is an imaginary line used for illustrative purposes. During processing, the controller 500 can determine the value of the first angle 451 by applying the values of third distance 143 and the fourth distance 144 along with other data, such as the difference between the first distance 141 and the second distance 142, to a trigonometric function.

A first actuator 112 coupled to the payout hub 110 can be operable to adjust a position of the payout hub 110 in the first direction 101. The first actuator 112 can be, for example, a linear actuator that is adapted to adjust the position of the payout hub 110, which is coupled to roller bearings or bushings (not shown) that are configured to provide rotational motion about the rotational axis 111 and lateral displacement in the first direction 101. Adjusting the position of the payout hub 110 in the first direction 101 can be used to shift the payout roll 150 in the first direction 101, which changes the first angle 451. For example, shifting the payout roll 150 in the first direction 101 along the length of the substrate 450 in the second direction 102 can make the edge 454 of the substrate 450 parallel to the first sidewall 106 and can reduce the first angle 451 to zero.

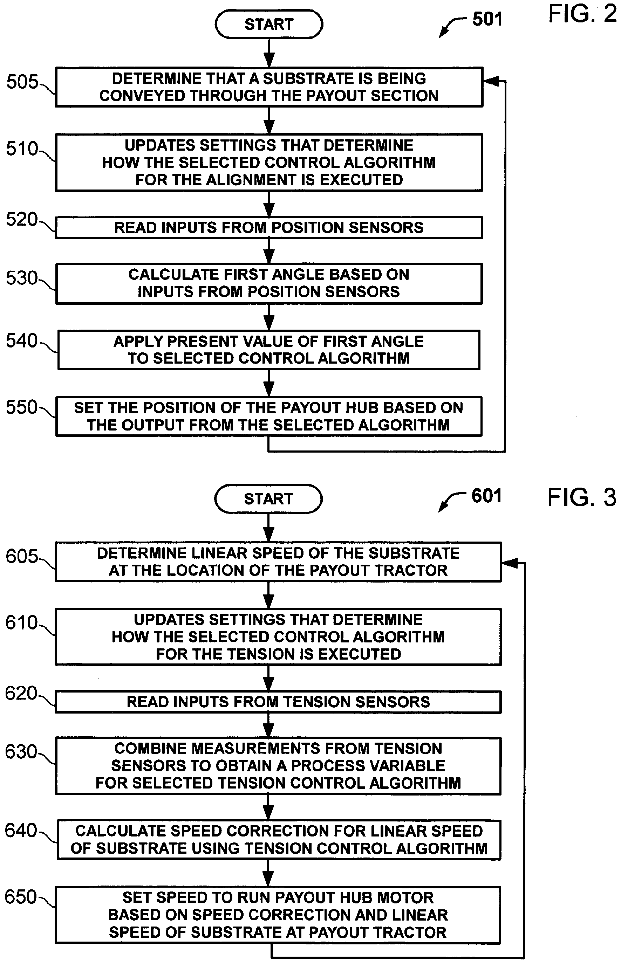

The controller 500 can be connected with the first position sensor 115, the second position sensor 116, and the first actuator 112. The controller 500 can be configured to adjust the position of the payout hub 110 in the first direction 101 through use of the first actuator 112 based on measurements of the third distance 143 and the fourth distance 144. The controller 500 can be configured to determine the first angle 451 between the edge 454 of the substrate 450 and the second direction 102 from the measurements of the third distance 143 and the fourth distance 144. In one embodiment, the controller 500 adjusts the position of the payout hub 110 in the first direction 101 through use of the first actuator 112 based on the first angle 451. For example, the controller 500 can adjust the position of the payout hub 110 in the first direction 101 in order to reduce the first angle 451 to zero. In another embodiment, the controller 500 is configured to adjust the position of the payout hub 110 in the first direction 101 in order to reduce a difference between the third distance 143 and the fourth distance 144 to zero. The controller can continuously receive feedback from the position sensors 115, 116 and determine when, how much, and at what rate to adjust the position of the payout hub 110 with the first actuator 112. During operation, the payout roll 150 may become telescoped in the first direction 101 with an uneven distribution as indicated by telescoped portion 152 in Figure 1B. The telescoping of the payout roll 150 can be caused by, for example, removal of air from the deposition chamber 20 and can lead to misalignment of the substrate 450 in the first direction 101 between the first position sensor 115 and the second position sensor 116. Further details about how the controller 500 adjusts the position of the payout hub 110 with the first actuator are described below in reference to Figure 2.

Figure 1C is a partial top view of the pickup section 200 of the deposition system 10, according to the embodiment of Figure 1A. The pickup section 200 includes a second frame 205 having a third sidewall 206 and a fourth sidewall 207 separated from each other in a third direction 203 (i.e., the Y-direction of Figure 1C). The second frame 205 can be used to provide structural support for at least some of the equipment in the pickup section 200, such as the pickup hub 210 and the first pickup roller 220. The pickup hub 210 may be disposed between and coupled to the third sidewall 206 and the fourth sidewall 207 of the second frame 205. The pickup hub 210 has a rotational axis 211 extending in the third direction 203. A pickup motor 214 can be coupled to the pickup hub 210 and can be used to rotate the pickup hub 210. The first pickup roller 220 is separated from the pickup hub 210 in a fourth direction 204 (i.e., the X-direction of Figure 1C). A length of the substrate 450 extends in the fourth direction 204 from the pickup hub 210 to the first pickup roller 220 during processing. The third direction 203 and the fourth direction 204 can each be horizontal and the fourth direction 204 can be substantially perpendicular to the third direction 203. Furthermore, in some embodiments, the first direction 101 and the third direction 203 can be the same direction. Similarly, in some embodiments, the second direction 102 can be the same as, or oriented 180 degrees relative to, the fourth direction 204. Moreover, in some embodiments one large frame can be used instead of a separate first frame 105 and second frame 205. In such embodiments using one large frame, the position sensors 115, 116, 215, 216 can each measure a distance from a same sidewall of the one large frame, and thus measure a distance from the same reference frame.

The third position sensor 215 is located a fifth distance 245 in the fourth direction 204 from the rotational axis 211 of the pickup hub 210. In one embodiment the third position sensor 215 may be located at a close distance from the pickup roll 250, such as within 3 cm of the surface of the pickup roll 250 when the pickup roll 250 has a maximum diameter. For example, in one embodiment the third position sensor 215 may be located at a minimum distance from that pickup roll 250 that still provides enough space to load or unload the pickup roll 250. The fourth position sensor 216 is located a sixth distance 246 in the fourth direction 204 from the rotational axis 211 of the pickup hub 210. The sixth distance 246 is further (e.g., from about 0.5 to about 4 times the width of the substrate 450, such as from about 1.5 to about 2 times the width of the substrate 450) from the pickup hub 210 than the fifth distance 245 is from the pickup hub 210. In some embodiments, the third position sensor 215 and the fourth position sensor 216 can be mounted to one of the sidewalls of the second frame 205, such as the third sidewall 206. The third position sensor 215 can be configured to measure a seventh distance 247 of the edge 454 of the substrate 450 from the third sidewall 206 at the fifth distance 245 from the pickup hub 210. The fourth position sensor 216 can be configured to measure an eighth distance 248 of the edge 454 of the substrate 450 from the third sidewall 206 at the sixth distance 246 from the pickup hub 210.

The measurements of the seventh distance 247 and the eighth distance 248 can be used to determine when the substrate 450 is aligned in the third direction 203 along the length of the substrate 450 in the fourth direction 204. For example, when the substrate 450 is aligned in the third direction 203 along the length of the substrate 450 in the fourth direction 204, the seventh distance 247 and the eighth distance 248 are equal when the third sidewall 206 and the fourth direction 204 are parallel. When the substrate 450 is not aligned in the third direction 203 along the length of the substrate 450 in the fourth direction 204, a second angle 452 is formed between the edge 454 of the substrate 450 and a second line 208 that is parallel to the fourth direction 204. The second line 208 can also be parallel to the third sidewall 206. In Figure 1C, the second line 208 extending from the edge 454 of the substrate 450 at the location of the fourth position sensor 216 is used as an example, but the first line may extend from other locations as well. The edge 454 of the substrate 450 can be the edge of the substrate 450 that is closest to the third sidewall 206. The second line 208 is an imaginary line used for illustrative purposes. During processing, the controller 500 can determine the value of the second angle 452 by applying the values of seventh distance 247 and the eighth distance 248 along with other data, such as the difference between the fifth distance 245 and the sixth distance 246, to a trigonometric function. Rates of change of distances or computed angles may also be processed or output by the controller 500.

A second actuator 212 coupled to the pickup hub 210 can be operable to adjust the position of the pickup hub 210 in the third direction 203. The second actuator 212 can be, for example, a linear actuator that is adapted to adjust the position of the pickup hub 210, which is coupled to roller bearings or bushings (not shown) that are configured to provide rotational motion about the rotational axis 211 and lateral displacement in the third direction 203. Adjusting the position of the pickup hub 210 in the third direction 203 can be used to shift the pickup hub 210 in the third direction 203, which changes the second angle 452. For example, shifting the pickup hub 210 in the third direction 203 along the length of the substrate 450 in the fourth direction 204 can make the edge 454 of the substrate 450 parallel to the third sidewall 206 and can reduce the second angle 452 to zero.

The controller 500 can be connected with the third position sensor 215, the fourth position sensor 216, and the second actuator 212. The controller 500 can be configured to adjust the position of the pickup hub 210 in the third direction 203 through use of the second actuator 212 based on measurements of the seventh distance 247 and the eighth distance 248. The controller 500 can be configured to determine the second angle 452 between the edge 454 of the substrate 450 and the fourth direction 204 from the measurements of the seventh distance 247 and the eighth distance 248. In one embodiment, the controller 500 adjusts the position of the pickup hub 210 in the third direction 203 through use of the second actuator 212 based on the second angle 452. For example, the controller 500 can adjust the position of the pickup hub 210 in the third direction 203 in order to reduce the second angle 452 to zero. In another embodiment, the controller 500 is configured to adjust the position of the pickup hub 210 in the third direction 203 in order to reduce a difference between the seventh distance 247 and the eighth distance 248 to zero. The controller can continuously receive feedback from the position sensors 215, 216 and determine when, how much, and at what rate to adjust the position of the pickup hub 210 with the second actuator 212.

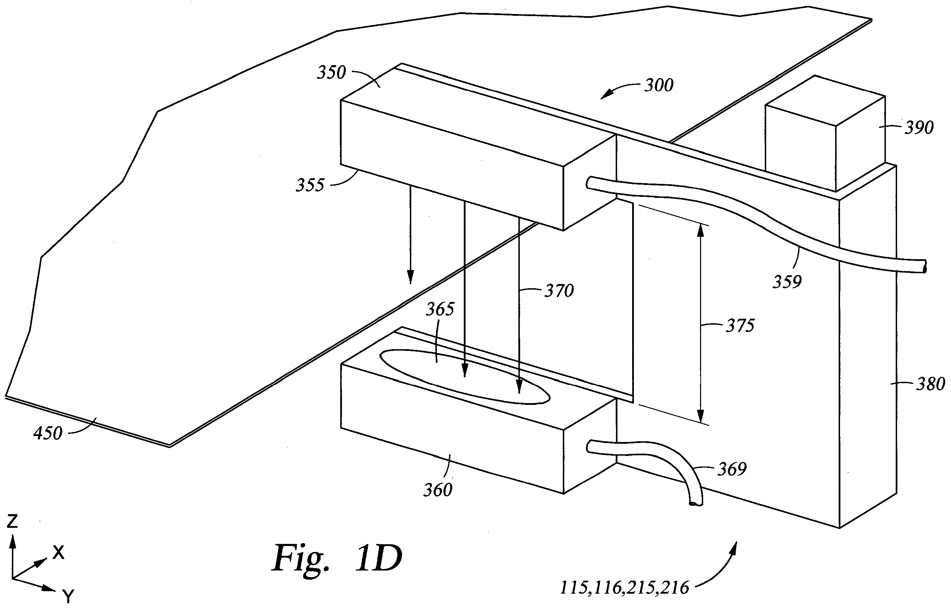

Figure 1D is a perspective view of an exemplary sensor assembly 300 to be used in the deposition system of Figure 1A, according to one embodiment. The exemplary sensor assembly 300 may be used for one or more of the position sensors 115, 116, 215, and 216. The sensor assembly 300 can be an optical sensor assembly, such as an optical sensor assembly using blue, violet, or ultraviolet light as a light source for position detection of the edge 454 of the substrate 450. The sensor assembly 300 can include a light case 350 for housing a light source 355. In some embodiments, the light case 350 can be formed of a metallic material, such as chromed steel, to provide an adequate heat sink for the sensor assembly 300. The light source 355 can be connected to a light source cable 359. In some embodiments, the light source cable 359 can be connected to the controller 500 to enable control of the light source 355 from the controller 500. The sensor assembly 300 can include a sensor case 360 for housing a light sensor 365. In some embodiments, the sensor case 360 can be formed of a metallic material, such as chromed steel, to provide an adequate heat sink for the sensor assembly 300. The light sensor 365 can be connected to a sensor cable 369. The sensor cable 369 can be connected to the controller 500 to enable monitoring of the signals from the light sensor 365. During operation, the light case 350 can be positioned above the substrate 450 and the sensor case 360 can be positioned below the substrate 450 at the various locations in the deposition system 10 (see Figure 1A) where the sensor assembly can be used, such as the locations of the position sensors 115, 116, 215, 216. A gap 375 between the light case 350 and the sensor case 360 can be longer for the position sensors 115, 215 than for the position sensors 116, 216 to account for the significant changes in diameter of the payout roll 150 and the pickup roll 250 during operation that can more significantly change the elevation of the substrate 450 at the locations of the position sensors 115, 215.

The edge 454 of the substrate 450 is disposed between the light case 350 and the sensor case 360 during operation. During operation, the light source 355 can emit light rays 370 towards the light sensor 365 and a portion of the light rays 370 are blocked by the substrate 450. The amount of light from the light source 355 that reaches the light sensor 365 varies with the position of the substrate 450 in the Y-direction of Figure 1D. The controller 500 monitors the signals from the light sensor 365 for each of the position sensors 115, 116, 215, 216 to determine the position of the edge 454 of the substrate 450 at the different locations in the deposition system 10.

The light case 350 and the sensor case 360 can be mounted to a frame 380, which can be mounted to one of the sidewalls of one of the frames, such as the first sidewall 106 of the first frame 105 (see Figure 1B). The frame 380 can be formed of a metallic material, such as steel, to act as a heat sink for the sensor assembly 300. The use of a frame material that has a desirable thermal conductivity can be useful to prevent thermal expansion during processing from affecting or distorting the position of the components in the sensor assembly 300. In some embodiments, a third actuator 390 can be used to change the vertical location of the light case 350 and the sensor case 360 during operation. The third actuator can be, for example, a linear actuator. Using the third actuator 390 allows for vertical adjustment of the light case 350 and the sensor case 360 to track the vertical location of the substrate 450 as the diameters of the payout roll 150 and the pickup roll 250 change during operation.

One will note that use of a thermally conductive frame material within the deposition assembly 11 will also help prevent the excessive movement of the position sensors 115, 116, 215 and 216, relative to each other during processing. Therefore, in some configurations, at least the frame 380, the first frame 105 and the second frame 205 are formed of a metallic material, such as steel.

Figure 2 is a process flow diagram of a method 501 to control the alignment of the substrate 450, according to one embodiment. Although the method 501 is described in reference to the blocks shown on Figure 2, persons skilled in the art would understand that any suitably adapted deposition system configured to perform the method steps, in any order, is within the scope of the embodiments disclosed. The method 501 is an exemplary control algorithm that can be executed by the controller 500 to control the alignment of the substrate 450 while the substrate 450 is being conveyed through the payout section 100 and/or the pickup section 200 of the deposition system 10 of Figure 1A. Thus, in some embodiments, the controller 500 executes a first instance of the method 501 to control the alignment of the substrate 450 in the payout section 100 and executes a second instance of the method 501 to control the alignment of the substrate 450 in the pickup section 200. The remainder of the description of Figure 2 describes execution of the method 501 for the payout section 100, but the same method can be executed for the pickup section 200 by changing the inputs and outputs of the method 501, such as the settings, sensor measurements (e.g., measurement from position sensor 215), and the output signal to change the position of the pickup hub 210 through use of the second actuator 212.

At block 505, the controller 500 determines that the substrate 450 is being conveyed through the payout section. The controller 500 can make this determination by monitoring one or more inputs to the controller 500. For example, in one embodiment, the controller 500 can use a motor feedback signal for the payout hub motor 114 as well as a tension above a threshold (e.g., a tension measurement from the first payout tension sensor 131) to determine that the substrate 450 is being conveyed through the payout section 100. In another embodiment, the controller 500 can determine that a substrate 450 is being conveyed through the system based on a startup sequence (not shown) being executed or completed.

At block 510, the controller 500 updates settings that determine how the control algorithm for the alignment is executed. An update may not be necessary if the previous settings are to be used again. One of the settings that the controller 500 can use to execute the control algorithm for the alignment can include the selected alignment control algorithm, such as a lookup table, proportional-integral-derivative (PID) control loop, or a fuzzy logic routine. Other settings can include a setpoint for the first angle 451 (i.e., generally zero) or for the position of the edge 454 of the substrate at the location of each position sensor 115, 116. Other settings can include a position or angle tolerance (i.e., for the first angle 451 described above), and a maximum deviation for the angle (such as within about ±2.5 degrees, such as within about ±1.4 degrees) or relative position (e.g., 2.5 mm) from a respective setpoint before an alarm is triggered to stop the deposition assembly 11. The position or angle tolerance can be a deadband in which the controller 500 will not adjust the output sent to the first actuator 112 to control the position of the payout hub 110 if the position or angle of the edge 454 of the substrate 450 has only deviated by a small amount from a setpoint. For example, a deadband setting of 0.5 mm can be used to prevent the controller 500 from adjusting the position of the payout hub 110 unless the position of the edge 454 of the substrate deviates by at least 0.5 mm. Other settings that can be used to determine how the control algorithm for the alignment is executed can include maximum rates of change for correction of the first angle 451 and/or the position of the payout hub 110 and data about the locations of the first and second position sensors 115, 116 and the first actuator 112.

At block 520, controller 500 reads the inputs received from the position sensors 115, 116. At block 530, the first angle 451 is calculated based on the inputs from the position sensors 115, 116 and other data, such as the distance between the position sensors 115, 116. As described above, in some embodiments, the controller 500 can alternatively use the first actuator 112 to change the position of the payout hub 110 to make the measurements from the position sensors 115, 116 equal or to a specified difference, and calculation of the first angle 451 may not be done in such embodiments.

At block 540, the controller 500 applies the present value of the first angle 451 to the selected alignment control algorithm, such as the lookup table, the PID control loop, or the fuzzy logic routine. As described above, the alignment control algorithm may keep the output the same when making the update when the input to the control algorithm is within the deadband.

At block 550, the controller 500 sends a signal to the first actuator 112 to set the position of the payout hub 110 based on the output from the selected control algorithm. After block 550, the method 501 continually loops through blocks 505-550 allowing the controller 500 to make adjustments to the position of the payout hub 110 using the first actuator 112 to maintain the alignment of the substrate 450 based on the measurements from the position sensors 115, 116 while the substrate 450 is being conveyed through the payout section 100.

In some embodiments, the controller 500 may include another control algorithm to control an offset between the edge 454 of the substrate 450 and one of the sidewalls 106, 107 in the payout section 100. For example, if the offset between the edge 454 and one of the sidewalls 106, 107 exceeds a maximum offset, then this control algorithm may include a function to shift the payout hub 110 for guiding the edge 454 towards a setpoint for the offset (e.g., zero mm) or towards a position that provides an operating margin, such as about 10 mm inward from the maximum offset. The controller 500 may disable the control algorithm for the alignment (e.g., the PID loop described above) during periods when the controller 500 is adjusting the position of the payout hub 110 to control the offset between the edge 454 of the substrate 450, and then re-enable the control algorithm for the alignment when the offset is reduced below the maximum offset. Furthermore, this guiding of the substrate 450 to control the offset can be used while the first angle 451 remains within operating margins, such as within about ±2.5 degrees, such as within about ±1.4 degrees.

In some embodiments, instead of using a separate control algorithm to adjust the position of the payout hub 110 to control the offset between the edge 454 of the substrate 450 and one of the sidewalls 106, 107, upon exceeding the maximum offset, the controller may raise an alarm, such as a visual alarm on a display, a light indicator on the deposition system 10, or an auditory signal. The controller 500 may further enable an operator to use the operator station 502 to manually initiate an adjustment to the position of the payout hub 110 using the operator station 502 to guide the motion of the edge 454 towards a desired offset, for example the desired setpoint. The controller 500 may further allow for the offset between the edge 454 of the substrate 450 and one of the sidewalls 106, 107 to be adjusted at a desired rate, such as a specific mm/minute. The controller 500 may further only allow these manually initiated adjustments of the position of the payout hub while the first angle 451 remains within a desired angle range as the substrate 450 transitions towards the desired offset setpoint. The controller 500 may also include similar instructions to simultaneously adjust the position of the pickup hub 210 to control the offset between the edge 454 of the substrate 450 and one of the sidewalls 206, 207 in the pickup section 200 in a similar manner to controlling the offset of the edge 454 in the payout section 100.

By using the position sensors 115, 116 in the payout section 100, the alignment of the substrate 450 can continuously be monitored, and the controller 500 can further continuously determine whether to adjust the position of the payout hub 110 through use of the first actuator 112 if a misalignment is detected. The substrate 450 can become misaligned during operation in the payout section 100 despite previously being properly aligned during startup of the deposition system 10. For example, the payout roll 150 may not be perfectly wound and can be slightly telescoped in a radial direction (i.e., Y-direction in Figure 1A). Furthermore, the processing environment (e.g., vacuum environment) inside the deposition chamber 20 can cause the payout roll 150 to telescope on the payout roll 150 due to gas trapped between the wound layers of the flexible substrate 450 escaping during the initial pump down of the deposition chamber 20 or later during the unwinding process performed during substrate processing. For example, the controller 500 can be configured to command the payout hub 110 to unwind the substrate 450 from the payout roll 150 disposed on the payout hub 110, and also to remove air from the deposition chamber 20, which can cause the payout roll 150 to telescope with an uneven distribution in the first direction 101. The substrate 450 can become misaligned in the first direction 101 between the position sensors 115, 116 when the payout roll 150 telescopes in the first direction 101. Also, the width of the substrate 450 may not be constant along the length of the substrate 450, which can also cause alignment issues. For example, heat from previous processing steps used to form the substrate 450 or heat exposure during transport through the processing section 400 can cause shrinkage of the flexible substrate 450, which can cause alignment issues. By continuously correcting misalignments of the substrate 450, the formation of waves or wrinkles along the substrate 450 can be prevented along with the problems associated with the waves, such as increased stress on portions of the substrate 450. By maintaining alignment of the substrate 450 by preventing these waves and unnecessary stresses on the substrate 450, product quality and yield can be improved. Similar benefits are obtained by maintaining the alignment of the substrate 450 in the pickup section 200 by using the measurements from the position sensors 215, 216 to adjust the position of the pickup hub 210 with the second actuator 212. The processes described herein can be useful in the process of forming flexible CIGS type thin film solar cell devices, due to the effect that the waves, wrinkles or stresses have on the active regions of the formed solar cell devices.

Figure 3 is a process flow diagram of a method 601 for controlling the tension on the flexible substrate 450, according to one embodiment. Although the method 601 is described in reference to the blocks shown on Figure 3, persons skilled in the art would understand that any suitably adapted deposition system configured to perform the method steps, in any order, is within the scope of the embodiments disclosed. The method 601 is described for controlling the tension at the location of the payout tension sensors 131, 132, but can also be similarly applied for maintaining the tension on the substrate 450 at the location of the pickup tension sensors 231, 232. The tension of the substrate 450 at the location of the payout tension sensors 131, 132 is maintained by having the payout hub motor 114 operate at a speed based on the speed of the payout tractors 410, 415 in a master-slave arrangement. To adjust the tension on the substrate 450, the payout hub motor 114 operates at a corrected speed to move the substrate 450 at the location of the payout hub 110 at a speed slightly offset from the speed of the substrate 450 at the location of the payout tractors 410, 415.

At block 605, the controller 500 determines the linear speed of the substrate 450 at the location of the payout tractor 410, also referred to as the master speed. In one embodiment, the controller 500 can convert the commanded speed at which the motor for the payout tractor 410 is operating to a linear speed of the substrate 450 using data about the motor and the payout tractor 410 as well as data about any gearboxes, pulleys or similar equipment used between the motor and the payout tractor 410. In another embodiment, one or more sensors, such as a tachometer, can be used to directly determine the speed of the payout tractor 410. Using a sensor to determine the speed of the payout tractor 410 can be useful in case there is a difference between commanded speed of the payout tractor 410 and actual speed. The tachometer measurement and data about the payout tractor 410 can then be used to determine the linear speed of the substrate 450 at the location of the payout tractor.

At block 610, the controller 500 updates settings that determine how the control algorithm for the tension is executed. An update may not be necessary if the previous settings are to be used again. One of the settings that the controller 500 can use to execute the control algorithm for the tension is the selected tension control algorithm, such as a lookup table, PID control loop, or a fuzzy logic routine. Another setting that the controller 500 can use to execute the control algorithm for the tension can include a setpoint for the speed of the payout tractor 410 or for the linear speed of the substrate 450, which can be used to calculate the speed to run the payout tractor 410. Another setting that can be used to determine how the control algorithm for the tension is executed can include maximum acceleration and deceleration for the speed of the payout hub motor 114.

At block 620, the controller reads inputs from the payout tension sensors 131, 132 to determine the tension on the substrate 450 at the location of the payout tension sensors 131, 132. At block 630, the controller 500 combines the measurements from the payout tension sensors 131, 132 to obtain a process variable that can be used as the input for the selected tension control algorithm, such as the lookup table, PID control loop, or fuzzy logic routine. For example, in one embodiment an average tension can be calculated from the measurements from the payout tension sensors 131, 132 to use as the input for the selected tension control algorithm.

At block 640, a speed correction is calculated. The speed correction can be the output of the selected tension control algorithm, such as the lookup table, the PID control loop, or the fuzzy logic routine. The speed correction can be calculated as a speed correction for the linear speed of the substrate 450 to bring the tension of the substrate 450 at the location of the tension sensors 131, 132 closer to the setpoint for the tension. At block 650, the speed to run the payout hub motor 114 is set based on the speed correction and the linear speed of the substrate 450 calculated in block 605. For example, the speed correction can be added or subtracted from the linear speed of the substrate 450 based on whether a decrease or increase in tension is needed to calculate a corrected linear speed for the substrate 450 at the location of the payout hub motor 114. The corrected linear speed can then be converted to a commanded speed to run the payout hub motor 114 using data about the payout hub motor 114 and the payout hub 110 as well as any data about any gearboxes, pulleys or similar equipment being used between the payout hub motor and the payout hub 110. The commanded speed is sent to the payout hub motor 114 or a device used to control the speed of the payout hub motor 114, such as a variable frequency drive. After block 650, the method 601 continually loops through blocks 605-650 allowing the controller 500 to make adjustments to the speed of the payout hub motor 114 to control the tension of the substrate 450 at the location of the tension sensors 131, 132 while the substrate 450 is being conveyed through the payout section 100.

Maintaining proper tension on the substrate 450 throughout the deposition assembly 11 can ensure a uniform velocity of the substrate throughout the deposition assembly 11 and prevents unnecessary stresses on the substrate 450. Ensuring uniform velocity of the substrate 450 throughout the deposition assembly 11 can improve the uniformity of the depositions performed on the substrate 450 in the processing section 400. Preventing unnecessary stresses on the substrate 450 can improve product quality and yield. The method 601 has been described using the speed of the first payout tractor 410 as the speed used to determine the speed at which to run the payout hub motor 114, but in other embodiments, the speed of the second payout tractor 415 or one of the pickup tractors 420, 425 could also be used.

While the foregoing is directed to embodiments of the present invention, other and further embodiments of the invention may be devised without departing from the basic scope thereof. Therefore, the scope of the present invention is determined by the claims that.follow.

## Claims

1. A deposition system (10) for guiding a flexible substrate (450) along a path past one or more heating evaporation sources (30), the deposition system comprising:
a deposition chamber (20), comprising:
a payout hub (110) for unwinding a flexible substrate (450) in a -X-direction;
a first actuator (112) coupled to the payout hub (110), the first actuator operable to adjust a position of the payout hub in a Y-direction perpendicular to the X-direction;
a first optical position sensor assembly (115) configured for measuring a position in the Y-direction and located a first distance in the -X-direction from the payout hub;
a second optical position sensor assembly (116) configured for measuring a position in the Y-direction and located a second distance in the -X-direction from the payout hub;
one or more payout tractors (410, 415) positioned to engage a side of the flexible substrate (450) when looking down a -Z-direction; and
one or more evaporation sources (30) for heating material inside the one or more of the evaporation sources (30) and directing evaporated material towards a front side (450A) of the flexible substrate (450) facing the one or more evaporation sources (30) as the flexible substrate (450) is conveyed past the one or more evaporation sources (30) in an X-direction;
and
a pickup hub (210);
wherein
the first optical position sensor assembly (115) is configured to measure a third distance of an edge (454) of the flexible substrate (450) in the Y-direction;
the second optical position sensor assembly (116) is configured to measure a fourth distance of the edge of the flexible substrate (450) in the Y-direction;
an optical position sensor assembly (115, 116) comprises a light source (355) positioned above the flexible substrate (450) for emitting blue, violet, or ultraviolet light rays (370) towards a light sensor (365) positioned below the flexible substrate (450); and
there is no line of sight in the deposition chamber (20) from the one or more evaporation sources (30) to any of the optical position sensor assemblies (115, 116) when the flexible substrate (450) is connected from the payout hub (110) to the pickup hub (210).

2. The deposition system of claim 1, further comprising:
a controller (500) connected with the first sensor (115), the second sensor (116), and the first actuator (112), the controller configured to adjust the position of the payout hub in the Y-direction through use of the first actuator based on measurements of the third distance and the fourth distance.

3. The deposition system of claim 2, wherein the controller is configured to:
determine a first angle (451) between the edge of the substrate (454) and the X-direction from the measurements of the third distance and the fourth distance; and
adjust the position of the payout hub in the Y-direction through use of the first actuator (112) based on the first angle.

4. The deposition system of claim 2, wherein the controller is configured to adjust the position of the payout hub in the Y-direction based on a difference between the third distance and the fourth distance.

5. The deposition system of claim 2, further comprising:
a second roller (220) positioned apart from the pickup hub in the X-direction (204), wherein a length of the substrate extends in the X-direction from the pickup hub to the second roller during processing;
a third sensor (215) located a fifth distance (245) in the X-direction from the pickup hub;
a fourth sensor (216) located a sixth distance (246) in the X-direction from the pickup hub, wherein the third sensor (215) is configured to measure a seventh distance of the edge of the substrate in the Y-direction at the fifth distance from the pickup hub and the fourth sensor (216) is configured to measure an eighth distance of the edge of the substrate in the Y-direction at the sixth distance from the pickup hub (210); and
a second actuator (212) coupled to the pickup hub, the second actuator operable to adjust the position of the pickup hub (210) in the Y-direction.

6. The deposition system of claim 5, wherein the controller (500) is connected with the third sensor (215), the fourth sensor (216), and the second actuator (212) and the controller is configured to adjust the position of the pickup hub (210) in the Y-direction through use of the second actuator (212) based on measurements of the seventh distance and the eighth distance.

7. The deposition system of claim 6, wherein the controller (500) is configured to:
determine a second angle (452) between the edge of the substrate (454) and the X-direction from the measurements of the seventh distance and the eighth distance; and
adjust the position of the pickup hub (210) in the Y-direction through use of the second actuator (212) based on the second angle.

8. The deposition system of claim 1, further comprising a third actuator (390) operable to adjust a vertical position of the first sensor (115).

9. The deposition system of claim 1, further comprising a heating assembly (460) comprising a plurality of heating elements and facing a backside (450B) of the flexible substrate (450).

10. The deposition system of claim 9, wherein the plurality of heating elements of the heating assembly (460) are independently controllable.

11. The deposition system of claim 1, further comprising:
a first roller (120) positioned apart from the payout hub in the -X-direction.

12. The deposition system of claim 2, further comprising:
a payout roll (150) disposed on the payout hub (110); and
a deposition chamber (20), wherein the controller (500) is further configured to:
unwind the flexible substrate (450) from the payout roll (150), wherein the payout roll (150) comprises a telescoped portion (152) with an uneven distribution of the flexible substrate (450) in the Y-direction.

13. A method of depositing a layer on a flexible substrate (450) in a deposition chamber (20) past one or more evaporation sources (30), comprising:
conveying the flexible substrate (450) between a payout hub (110) and a pickup hub (210) in the deposition chamber (20), wherein the conveying comprises:
unwinding the flexible substrate (450) from the payout hub (110) in a -X-direction; and
engaging a side of the flexible substrate (450) when looking down a -Z-direction into one or more payout tractors (410, 415);
measuring a third distance (143) in a Y-direction perpendicular to the X-direction of an edge (454) of the flexible substrate (450) using a first optical position sensor assembly (115) located at a first distance (141) from the payout hub (110);
measuring a fourth distance (144) in the Y-direction of the edge (454) of the flexible substrate (450) using a second optical position sensor assembly (116) located at a second distance (142) from the payout hub (110);
depositing one or more materials on the substrate (450) using one or more evaporation sources (30) for heating material inside the one or more of the evaporation sources (30) and directing evaporated material towards a front side (450A) of the flexible substrate (450) facing the one or more evaporation sources (30) as the flexible substrate (450) is conveyed past the one or more evaporation sources (30) in an X-direction; and
adjusting a position of the payout hub (110) in the Y-direction through use of a first actuator (112) coupled to the payout hub (110) based on the measurements of the third distance (143) and the fourth distance (144); wherein
an optical position sensor assembly (115, 116) comprises a light source (355) positioned above the flexible substrate (450) for emitting blue, violet, or ultraviolet light rays (370) towards a light sensor (365) positioned below the flexible substrate (450); and
there is no line of sight in the deposition chamber (20) from the one or more evaporation sources (30) to any of the optical position sensor assemblies (115, 116) when the flexible substrate (450) is connected from the payout hub (110) to the pickup hub (210).

14. The method of claim 13, further comprising:
determining a first angle (451) between the edge (454) of the flexible substrate (450) and the -X-direction from the measurements of the third distance (143) and the fourth distance (144); and
adjusting the position of the payout hub (110) in the Y-direction through use of the first actuator (112) based on the first angle (451).

15. The method of claim 13, further comprising adjusting the position of the payout hub (110) in the Y-direction based on a difference between the third distance (143) and the fourth distance (144).

## Patentansprüche

1. Ein Abscheidungssystem (10) zum Führen eines flexiblen Substrats (450) entlang einem Weg über einer oder mehrer Verdampfungsquellen (30), wobei das Abscheidungssystem umfasst:
eine Abscheidungskammer (20), umfassend:
eine Abwickelnabe (110) zum Abwickeln eines flexiblen Substrats (450) in einer -X-Richtung;
einen ersten Aktuator (112), der mit der Abwickelnabe (110) gekoppelt ist, wobei der erste Aktuator verwendet wird um die Position der Abwickelnabe in Y-Richtung rechtwinklig zur X-Richtung einzustellen;
eine erste optische Positionssensorbaugruppe (115), konfiguriert zum Messen einer Position in Y-Richtung entfernt in einem ersten Abstand in -X-Richtung von der Abwickelnabe;
eine zweite optische Positionssensorbaugruppe (116) konfiguriert zum Messen einer Position in Y-Richtung entfernt in einem zweiten Abstand in -X-Richtung von der Abwickelnabe;
einer oder mehrere Abwickelantriebe (410, 415), positioniert um eine Seite des flexiblen Substrats (450) zu berühren nach unten in -Z-Richtung; und
eine oder mehrere Verdampfungsquellen (30) zum Erhitzen des Materials aus einer oder mehrerer der Verdampfungsquellen (30) und das Führen des verdampften Materials auf eine Vorderseite (450A) des flexiblen Substrats (450), zugewandt der einen oder den mehreren Verdampfungsquellen (30) während das flexible Substrat (450) fortbewegt wird über der einen oder den mehreren Verdampfungsquellen (30) in einer X-Richtung;
und
eine Aufwickelnabe (210);
wobei
die erste optische Positionssensorbaugruppe (115) konfiguriert ist, um einen dritten Abstand einer Kante (454) des flexiblen Substrats (450) in Y-Richtung zu messen;
die zweite optische Positionssensorbaugruppe (116) ist konfiguriert um einen vierten Abstand der Kante des flexiblen Substrats (450) in Y-Richtung zu messen;
eine optische Positionssensorbaugruppe (115, 116) umfasst eine Lichtquelle (355), positioniert über dem flexiblen Substrat (450) um blaue, violette oder ultraviolette Lichtstrahlen auszustrahlen (370) in Richtung eines Lichtsensors (365) positioniert unter dem flexiblen Substrat (450); und
es gibt keine Sichtlinie in der Abscheidungskammer (20) von der einen oder den mehreren Verdampfungsquellen (30) zu einer der optischen Positionssensorbaugruppen (115, 116), wenn das flexible Substrat (450) eingebaut ist von der Abwickelnabe (110) zur Aufwickelnabe (210).

2. Abscheidungssystem nach Anspruch 1, ferner umfassend:
eine Steuerung (500), verbunden mit dem ersten Sensor (115), dem zweiten Sensor (116) und dem ersten Aktuator (112), wobei die Steuerung konfiguriert ist, die Position der Abwickelnabe in der Y-Richtung einzustellen unter Verwendung des ersten Aktuators basierend auf Messungen des dritten Abstandes und des vierten Abstandes.

3. Abscheidungssystem nach Anspruch 2, wobei die Steuerung konfiguriert ist zur:
Bestimmung eines ersten Winkels (451) zwischen der Kante des Substrats (454) und der X-Richtung aus den Messungen des dritten Abstands und des vierten Abstands; und
einzustellen die Position der Abwickelnabe in Y-Richtung mithilfe des ersten Aktuators (112) basierend auf dem ersten Winkel.

4. Abscheidungssystem nach Anspruch 2, wobei die Steuerung konfiguriert ist, die Position der Abwickelnabe in der Y-Richtung einzustellen, basierend auf einer Differenz zwischen des dritten Abstand und des vierten Abstand.

5. Abscheidungssystem nach Anspruch 2, ferner umfassend:
Eine zweite Rolle (220), positioniert unabhängig von der Aufwickelnabe in der X-Richtung (204), wobei sich eine Länge des Substrats erstreckt in X-Richtung von der Aufnahmenabe zur zweiten Rolle während dem Prozess;
einen dritten Sensor (215), der sich in einem fünften Abstand (245) in der X-Richtung von der Aufnahmenabe befindet;
einen vierten Sensor (216), angeordnet in einem sechsten Abstand (246) in der X-Richtung von der Aufnahmehabe, wobei der dritte Sensor (215) konfiguriert ist, einen siebten Abstand zu messen von der Kante des Substrats in der Y-Richtung beim fünften Abstand von der Aufwickelnabe und der vierte Sensor (216) ist konfiguriert, um einen achten Abstand zu messen von der Kante des Substrats in Y-Richtung beim sechsten Abstand von der Aufwickelnabe (210); und
einen zweiten Aktuator (212), gekoppelt mit der Aufwickelnabe, wobei der zweite Aktuator verwendet wird, um die Position der Aufwickelnabe (210) in der Y-Richtung einzustellen.

6. Abscheidungssystem nach Anspruch 5, wobei die Steuerung (500) verbunden ist mit dem dritten Sensor (215), dem vierten Sensor (216) und dem zweiten Aktuator (212) und die Steuerung konfiguriert ist um die Position der Aufwickelnabe (210) einzustellen in der Y-Richtung durch Verwendung des zweiten Aktuators (212) basierend auf Messungen des siebten Abstands und des achten Abstands.

7. Abscheidungssystem nach Anspruch 6, wobei die Steuerung (500) konfiguriert ist:
zur Bestimmung eines zweiten Winkels (452) zwischen der Kante des Substrats (454) und der X-Richtung aus den Messungen des siebten Abstands und des achten Abstands; und
zur Einstellung der Position der Aufwickelnabe (210) in Y-Richtung durch Verwendung des zweiten Aktuators (212) basierend auf dem zweiten Winkel.

8. Abscheidungssystem nach Anspruch 1, ferner umfassend einen dritten Aktuator (390), der einsetzbar ist, um eine vertikale Position des ersten Sensors (115) einzustellen.

9. Abscheidungssystem nach Anspruch 1, ferner umfassend eine Heizeranordnung (460), die mehrere Heizelemente umfasst und einer Rückseite (450B) des flexiblen Substrats (450) zugewandt ist.

10. Abscheidungssystem nach Anspruch 9, wobei die Heizelemente der Heizeranordnung (460) unabhängig voneinander steuerbar sind.

11. Abscheidungssystem nach Anspruch 1, ferner umfassend:
eine erste Rolle (120), positioniert neben der Abwickelnabe in der -X-Richtung.

12. Abscheidungssystem nach Anspruch 2, ferner umfassend:
eine Abwickelrolle (150), befestigt an der Abwickelnabe (110); und
eine Abscheidungskammer (20), wobei die Steuerung (500) ferner konfiguriert ist, um:
das flexible Substrat (450) abzuwickeln von der Abwickelrolle (150), wobei die Abwickelrolle (150) einen teleskopierten Abschnitt (152) mit einer ungleichmäßigen Verteilung des flexiblen Substrats (450) in Y-Richtung umfasst.

13. Ein Verfahren zum Abscheiden einer Schicht auf einem flexiblen Substrat (450) in einer Abscheidungskammer (20) über einer oder mehreren Verdampfungsquellen (30), umfassend:
Fördern des flexiblen Substrats (450) zwischen einer Abwickelnabe (110) und einer Aufwickelnabe (210) in der Abscheidungskammer (20), wobei die Förderung umfasst:
Abwickeln des flexiblen Substrats (450) von der Abwickelnabe (110) in einer-X-Richtung; und
eine Seite des flexiblen Substrats (450) berührend in einer -Z-Richtung mit einem oder mehreren Abwickelantrieben (410, 415);
Messen eines dritten Abstands (143) in einer Y-Richtung senkrecht zur X-Richtung einer Kante (454) des flexiblen Substrats (450) unter Verwendung einer ersten optischen Positionssensorsbaugruppe (115), die sich in einem ersten Abstand (141) befindet von der Abwickelnabe (110);
Messen eines vierten Abstands (144) in der Y-Richtung der Kante (454) des flexiblen Substrats (450) unter Verwendung einer zweiten optischen Positionssensorsbaugruppe (116), die sich in einem zweiten Abstand (142) von der Abwickelnabe (110) befindet;
Abscheiden eines oder mehrerer Materialien auf dem Substrat (450) unter Verwendung einer oder mehrerer Verdampfungsquellen (30) zum Erhitzen von Material innerhalb der einen oder mehreren der Verdampfungsquellen (30) und Führen des verdampften Materials auf die Vorderseite (450A) des flexiblen Substrats (450) zugewandt einer oder den mehreren Verdampfungsquellen (30), während das flexible Substrat (450) in X-Richtung über der einen oder den mehreren Verdampfungsquellen (30) vorbeigeführt wird; und
Einstellen einer Position der Abwickelnabe (110) in Y-Richtung durch Verwendung eines ersten Aktuators (112), der mit der Abwickelnabe (110) gekoppelt ist, basierend auf den Messungen des dritten Abstands (143) und des vierten Abstands (144);
wobei
eine optische Positionssensorbaugruppe (115, 116), umfassend eine Lichtquelle (355), die über dem flexiblen Substrat (450) positioniert ist, um blaue, violette oder ultraviolette Lichtstrahlen auszustrahlen (370) in Richtung eines Lichtsensors (365), positioniert unter dem flexiblen Substrat (450); und
es gibt keine direkte Sichtlinie in der Abscheidekammer (20) von der einen oder den mehreren Verdampfungsquellen (30) zu einer der optischen Positionssensorbaugruppen (115, 116) wenn das flexible Substrat (450) verbunden ist von der Abwickelnabe (110) zur Aufwickelnabe (210).

14. Verfahren nach Anspruch 13, ferner umfassend:
Bestimmen eines ersten Winkels (451) zwischen der Kante (454) des flexiblen Substrats (450) und der -X-Richtung aus den Messungen des dritten Abstands (143) und des vierten Abstands (144); und
Einstellen der Position der Abwickelnabe (110) in der Y-Richtung durch Verwendung des ersten Aktuators (112) basierend auf dem ersten Winkel (451).

15. Verfahren nach Anspruch 13, ferner umfassend das Einstellen der Position der Abwickelnabe (110) in der Y-Richtung basierend auf einer Differenz zwischen des dritten Abstand (143) und des vierten Abstand (144).

## Revendications

1. Système de dépôt (10) pour guider un substrat flexible (450) le long d'un trajet devant une ou plusieurs sources d'évaporation chauffantes (30), le système de dépôt comprenant:
une chambre de dépôt (20), comprenant:
un moyeu de distribution (110) pour dérouler un substrat flexible (450) dans une direction -X;
un premier actionneur (112) couplé au moyeu de distribution (110), le premier actionneur pouvant fonctionner pour régler une position du moyeu de distribution dans une direction Y perpendiculaire à la direction X;
un premier assemblage de capteur de position optique (115) configuré pour mesurer une position dans la direction Y et situé à une première distance dans la direction -X du moyeu de distribution;
un deuxième assemblage de capteur de position optique (116) configuré pour mesurer une position dans la direction Y et situé à une deuxième distance dans la direction -X à partir du moyeu de distribution;
un ou plusieurs tracteurs de distribution (410, 415) positionnés pour venir en prise avec un côté du substrat flexible (450) lorsque l'on regarde vers le bas dans une direction -Z; et une ou plusieurs sources d'évaporation (30) pour chauffer le matériau à l'intérieur de l'une ou plusieurs des sources d'évaporation (30) et diriger le matériau évaporé vers une face avant (450A) du substrat flexible (450) faisant face à la ou les sources d'évaporation (30)) lorsque le substrat flexible (450) est transporté au-delà de la ou des sources d'évaporation (30) dans une direction X;
et
un moyeu de ramassage (210);
dans lequel
le premier assemblage capteur de position optique (115) est configuré pour mesurer une troisième distance d'un bord (454) du substrat flexible (450) dans la direction Y;
le deuxième assemblage de capteur de position optique (116) est configuré pour mesurer une quatrième distance du bord du substrat flexible (450) dans la direction Y;
un assemblage capteur de position optique (115, 116) comprend une source de lumière (355) positionnée au-dessus du substrat flexible (450) pour émettre des rayons de lumière bleue, violette ou ultraviolette (370) vers un capteur de lumière (365) positionné sous le substrat flexible (450); et
il n'y a pas de ligne de visée dans la chambre de dépôt (20) depuis la ou les sources d'évaporation (30) vers l'un quelconque des assemblages de capteurs de position optique (115, 116) lorsque le substrat flexible (450) est connecté depuis le moyeu de distribution (110) jusqu'au moyeu de ramassage (210).

2. Système de dépôt selon la revendication 1, comprenant en outre:un contrôleur (500) connecté au premier capteur (115), au deuxième capteur (116) et au premier actionneur (112), le contrôleur étant configuré pour ajuster la position du moyeu de distribution dans la direction Y grâce à l'utilisation du premier actionneur basé sur des mesures de la troisième distance et de la quatrième distance.

3. Système de dépôt selon la revendication 2, dans lequel le contrôleur est configuré pour:
déterminer un premier angle (451) entre le bord du substrat (454) et la direction X à partir des mesures de la troisième distance et de la quatrième distance; et
ajuster la position du moyeu de distribution dans la direction Y par l'utilisation du premier actionneur (112) sur la base du premier angle.

4. Système de dépôt selon la revendication 2, dans lequel le contrôleur est configuré pour ajuster la position du moyeu de distribution dans la direction Y sur la base d'une différence entre la troisième distance et la quatrième distance.

5. Système de dépôt selon la revendication 2, comprenant en outre:
un deuxième rouleau (220) positionné à l'écart du moyeu de prise dans la direction X (204), dans lequel une longueur du substrat s'étend dans la direction X depuis le moyeu de ramassage jusqu'au deuxième rouleau pendant le traitement;
un troisième capteur (215) situé à une cinquième distance (245) dans la direction X à partir du moyeu de prise;
un quatrième capteur (216) situé à une sixième distance (246) dans la direction X à partir du moyeu de ramassage, dans lequel le troisième capteur (215) est configuré pour mesurer une septième distance du bord du substrat dans la direction Y à la cinquième distance du moyeu de ramassage et le quatrième capteur (216) est configuré pour mesurer une huitième distance du bord du substrat dans la direction Y à la sixième distance du moyeu de ramassage (210); et
un deuxième actionneur (212) couplé au moyeu de ramassage, le deuxième actionneur opérable pour régler la position du moyeu de ramassage (210) dans la direction Y.

6. Système de dépôt selon la revendication 5, dans lequel le contrôleur (500) est connecté au troisième capteur (215), au quatrième capteur (216) et au deuxième actionneur (212) et le contrôleur est configuré pour ajuster la position du moyeu de prise (210) dans la direction Y grâce à l'utilisation du deuxième actionneur (212) sur la base de mesures de la septième distance et de la huitième distance.

7. Système de dépôt selon la revendication 6, dans lequel le contrôleur (500) est configuré pour:
déterminer un deuxième angle (452) entre le bord du substrat (454) et la direction X à partir des mesures de la septième distance et de la huitième distance; et
ajuster la position du moyeu de ramassage (210) dans la direction Y en utilisant le second actionneur (212) sur la base du second angle.

8. Système de dépôt selon la revendication 1, comprenant en outre un troisième actionneur (390) pouvant fonctionner pour régler une position verticale du premier capteur (115).

9. Système de dépôt selon la revendication 1, comprenant en outre un assemblage chauffant (460) comprenant une pluralité d'éléments chauffants et faisant face à une face arrière (450B) du substrat flexible (450).

10. Système de dépôt selon la revendication 9, dans lequel la pluralité d'éléments chauffants de l'assemblage chauffant (460) sont contrôlables indépendamment.

11. Système de dépôt selon la revendication 1, comprenant en outre:
un premier rouleau (120) positionné à l'écart du moyeu de distribution dans la direction -X.

12. Système de dépôt selon la revendication 2, comprenant en outre:
un rouleau de distribution (150) disposé sur le moyeu de distribution (110); et
une chambre de dépôt (20), dans laquelle le contrôleur (500) est en outre configuré pour:
dérouler le substrat flexible (450) du rouleau de distribution (150), dans lequel le rouleau de distribution (150) comprend une partie télescopique (152) avec une distribution inégale du substrat flexible (450) dans la direction Y.

13. Procédé de dépôt d'une couche sur un substrat flexible (450) dans une chambre de dépôt (20) devant une ou plusieurs sources d'évaporation (30), comprenant:
transporter le substrat flexible (450) entre un moyeu de distribution (110) et un moyeu de ramassage (210) dans la chambre de dépôt (20), dans lequel le transport comprend:
dérouler le substrat flexible (450) du moyeu de distribution (110) dans une direction -X; et
engager un côté du substrat flexible (450) lorsque l'on regarde vers le bas dans une direction -Z dans un ou plusieurs tracteurs de distribution (410, 415);
mesurer une troisième distance (143) dans une direction Y perpendiculaire à la direction X d'un bord (454) du substrat flexible (450) en utilisant un premier assemblage de capteur de position optique (115) situé à une première distance (141) du moyeu de distribution (110);
mesurer une quatrième distance (144) dans la direction Y du bord (454) du substrat flexible (450) en utilisant un deuxième assemblage de capteur de position optique (116) situé à une deuxième distance (142) du moyeu de distribution (110);
déposer un ou plusieurs matériaux sur le substrat (450) en utilisant une ou plusieurs sources d'évaporation (30) pour chauffer le matériau à l'intérieur de l'une ou plusieurs des sources d'évaporation (30) et diriger le matériau évaporé vers une face avant (450A) du substrat flexible (450) face à l'une ou plusieurs sources d'évaporation (30) lorsque le substrat flexible (450) est transporté devant l'une ou plusieurs sources d'évaporation (30) dans une direction X; et
ajuster une position du moyeu de distribution (110) dans la direction Y par l'utilisation d'un premier actionneur (112) couplé au moyeu de distribution (110) sur la base des mesures de la troisième distance (143) et de la quatrième distance (144);
dans lequel
un assemblage de capteur de position optique (115, 116) comprend une source de lumière (355) positionnée au-dessus du substrat flexible (450) pour émettre des rayons de lumière bleue, violette ou ultraviolette (370) vers un capteur de lumière (365) positionné sous le substrat flexible (450); et
il n'y a pas de ligne de visée dans la chambre de dépôt (20) depuis l'une ou plusieurs sources d'évaporation (30) vers l'un quelconque des assemblages de capteurs de position optique (115, 116) lorsque le substrat flexible (450) est connecté à partir du moyeu de distribution (110) jusqu'au moyeu de ramassage (210).

14. Procédé selon la revendication 13, comprenant en outre:
déterminer un premier angle (451) entre le bord (454) du substrat flexible (450) et la direction -X à partir des mesures de la troisième distance (143) et de la quatrième distance (144); et
ajuster la position du moyeu de distribution (110) dans la direction Y grâce à l'utilisation du premier actionneur (112) sur la base du premier angle (451).

15. Procédé selon la revendication 13, comprenant en outre l'ajustement de la position du moyeu de distribution (110) dans la direction Y sur la base d'une différence entre la troisième distance (143) et la quatrième distance (144).
